# EUROPEAN PATENT APPLICATION

(11) **EP 1 193 743 A1**
(43) Date of publication of application: **03.04.2002**
(21) Application number: 01480090.8
(22) Date of filing: 26.09.2001
(51) Int. Cl.: H01L 21/28, H01L 21/314, H01L 29/51, H01L 21/316, H01L 21/318

(54) **Formation of interfacial oxide layer at the SI3N4/SI interface by H2/O2 annealing**

(30) Priority: 28.09.2000 US 671215
(71) Applicant: CHARTERED SEMICONDUCTOR MANUFACTURING, INC., Milpitas, CA 95035 (US)
(72) Inventor: Wenhe, Lin, Singapore 730554 (SG); Zhong, Dong, Singapore 670106 (SG); King, Leong Pey, Singapore 659248 (SG); Simon, Chooi, Singapore 277596 (SG); Mei-Sheng, Zhou, Singapore 129791 (SG); Ting, Cheong Ang, Singapore 640425 (SG)
(74) Representative: Schuffenecker, Thierry

(57) **Abstract**

A method of forming an interfacial oxide layer at a semiconductor/ dielectric interface is disclosed. The method comprises the following steps. A partially processed semiconductor wafer is provided having semiconductor surfaces upon which gate dielectrics are to be disposed. These semiconductor surfaces are cleaned of contaminants and particles. A thin dielectric layer (14) is deposited on these semiconductor surfaces. The semiconductor wafer is then annealed in a gaseous environment to induce the growth of an oxide layer under the thin dielectric layer.

## Description

### Technical field

The present invention relates generally to semiconductor integrated circuit processing and more particularly to gate dielectric layers of MOSFET devices.

### Background art

The gate dielectric is perhaps the most sensitive component of modem CMOS devices. Requirements of appropriate dielectric layers include high dielectric breakdown strength, low leakage current, good diffusion barrier properties, low trapping densities and low interfacial states. As device dimensions decrease the requirements become more stringent and new gate dielectric structures are needed to meet the more stringent requirements. Silicon dioxide has been the most the most popular gate dielectric for many years. However, with the recent requirement for gate dielectric thickness of 15 Angstroms or less, excessive direct tunneling current limits the use of silicon dioxide as the gate dielectric. Silicon nitride is also a commonly used gate dielectric material, which, having a dielectric constant of∼ 7.5 as compared to ∼ 3.9 for silicon dioxide, is used to reduce the tunneling current.

Several layers are often used to achieve the various requirements, with different layers especially suited for a particular requirement. For instance, Si₃N₄ is an exceptionally good diffusion barrier material and an H₂/O₂ oxide layer, known as in-situ steam generation (ISSG) oxide, provides superior interfacial properties. Thus the combination of an ISSG oxide layer over silicon followed by a Si₃N₄ layer meets the requirements of modem gate dielectrics.

In U S. Pat. No. 4,849,366 to Hsu et al. a three-layer gate dielectric is disclosed comprised of oxide, silicon nitride and silicon oxynitride layers, which provided a radiation hardened CMOS isolation structure. Chau in U.S. Pat. No. 5,763,922 teaches the preference of having different dielectric layers for the gates of PMOS and NMOS devices, where the particular layer is chosen to optimize performance and reliability. He shows, for instance, that nitrogen rich silicon dioxide is preferred as the gate dielectric of NMOS transistors, while for PMOS transistors it is preferred that the silicon dioxide gate dielectric layer is less nitrogen rich. Chau also points out that a dry/wet oxidation process forms a robust gale dielectric layer. He also discusses the use of several layers, such as an oxide layer sad a nitride layer, as the gate dielectric. Bacchetta et al., U.S. Pat. No. 5,795,821 shows a three-layer dielectric film with improved adhesion. A thin silicon dioxide second layer interposed between a dielectric first layer and third layer serves as an adhesion layer between the first and third layer. In particular, the first and third layer could be silicon nitride or silicon oxynitride. U.S. Pat. No. 5,861,347 to Maiti et al. teaches a tunnel oxide process where the oxide is exposed to an N2 anneal leading to improved interface properties. A low temperature wet oxidation process utilizing HCL, H₂ and 0₂ is used to grow a high voltage gate dielectric. Yamazaki et al., U.S. Pat. No. 5,917,225 show a gate dielectric composed of an oxide layer and an added silicon nitride layer to serve as a diffusion barrier and to improve the breakdown characteristics.

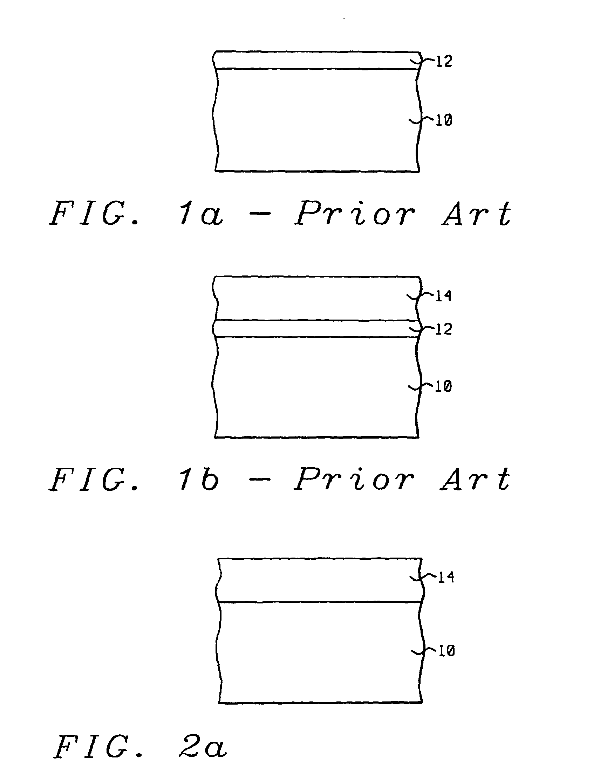

A conventional process flow to fabricate a two layer gate dielectric for modern submicron CMOS technology is shown in Figs. 1a and 1b. The process flow involves three steps. First a thin SiO₂ layer, 12, is grown over the silicon, 10, in a NO gaseous ambient, as shown in Fig. 1 a. A grown SiO₂ layer is chosen to achieve a low interfacial trap density. This layer could be about 7 angstroms thick and requires extremely precise process control. In practice the wafer to wafer reproducibility is poor so this process is essentially not manufacturable. A preferred alternative, an ISSG oxide layer that results in superior interfacial properties at the silicon interface, grows even faster and the process to grow an ultra-thin oxide layer (< 10 Angstroms) is uncontrollable. A CVD silicon nitride layer 14, is then deposited on the silicon dioxide layer as indicated in Fig. 1b. A Si₃N₄ layer is chosen because it is a superior barrier to contaminants, Finally, NH₃ and subsequent N₂O annealing is performed.

### Summary of the invention

It is a primary objective of the invention to provide a readily controlled and manufacturable process for fabricating a two-layer gate dielectric comprised of a grown ISSG silicon dioxide layer and a CVD silicon nitride layer. Such a gate dielectric has the advantages of superior interfacial properties and of being an excellent barrier to contaminants. The process of the invention also results in a significant improvement in the uniformity of the thickness of the gate dielectric.

In contrast to the conventional process, in the process of the invention the silicon nitride layer is deposited directly on the silicon substrate after RCA clean. The wafer is then annealed in a H₂/0₂ gas mixture. Though silicon nitride has good barrier properties and strongly resists oxidation, nevertheless an oxide layer is developed in this annealing step. The growth rate depends strongly on the thickness of the nitride layer so that a sufficiently thin silicon nitride layer is required to achieve a silicon dioxide layer in a reasonable time. This dependence of silicon dioxide growth rate on silicon nitride layer thickness gives rise to an improvement in the uniformity of gate dielectric thickness over that achieved by conventional processing. This is because a thicker silicon dioxide layer is grown under thinner silicon nitride, which tends to diminish the difference.

Control of the grown silicon dioxide layer is geatly improved because the growth rate is slowed down by the need of the oxygen and hydrogen to diffuse through the silicon nitride layer. Small differences in oxidation time are not critical, since they only result in small differences in silicon dioxide thickness, and thus improved process reproducibility is achieved. The process of the invention renders the ISSG silicon dioxide-silicon nitride gate dielectric a manufacturable structure.

Other embodiments of the invention enable it to be applied to silicon nitride layers too thick to permit forming an appropriate silicon dioxide layer beneath it. The silicon nitride layer is deposited in two steps. First a silicon nitride layer is deposited to a thickness appropriate to the growth of the silicon dioxide layer beneath it. Subsequently the thickness is increased by a second silicon nitride deposition to the desired total silicon nitride layer thickness.

### Description of the drawings

In the accompanying drawing forming a material part of this description, there is shown:

Figs. 1a and 1b show a conventional process.

Figs. 2a and 2b show a process according to the invention.

Fig. 3 explains the improvement of gate dielectric thickness uniformity.

Fig. 4 shows the improvement of gate dielectric thickness uniformity

### Description of the preferred embodiments

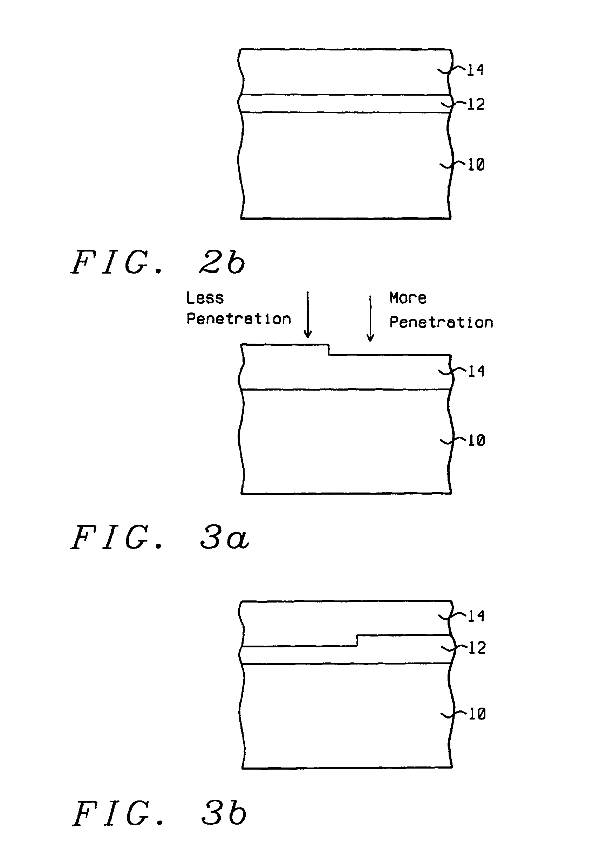

Figs. 2a and 2b illustrate the process according to preferred embodiments of the invention. After RCA cleaning of the silicon surface, to eliminate particles and contamination, a CVD silicon nitride layer, 14 in Fig. 1a, is deposited directly on the silicon surface. An annealing step follows in an H₂/O₂ gas mixture. A silicon oxide layer, 12. develops under the silicon nitride, as shown in Fig. 2b. The growth rate of the silicon dioxide layer is a strong function of the silicon nitride thickness because the oxygen and hydrogen must diffuse through the silicon nitride layer before reacting with the silicon. Thus for thick silicon nitride layers the oxygen and hydrogen penetration is too low, and a silicon dioxide layer does not develop. However, for a sufficiently thin silicon nitride layer, and this depends on other growth conditions, notably the temperature, a silicon dioxide layer does develop within a reasonable time. Major advantages of the invention stem from this affect.

RCA cleaning procedures, to eliminate particles and contaminants from surfaces are well known to those skilled in the art. A clean surface is necessary to insure the integrity of the gate dielectric that is being formed. Preferably, a CVD silicon nitride layer is deposited using LPCVD or RTCVD techniques. The thickness of the silicon nitride layer could be between about 8 to about 25 Angstroms. At such thickness the advantages of silicon nitride as a barrier layer are realized at the temperatures encountered during device operation, yet the layer is thin enough to grow an appropriate oxide layer at oxidation temperatures. The H₂/O₂ anneal, during which the underlying silicon dioxide layer is grown, can be performed at temperatures from about 700 to 1000 degrees Celsius. pressures from about 1 to 100 Tort, H₂/O₂ ratios from about 1:500 to 1:20 and duration from about 5 to 60 seconds. This H₂/O₂ oxidation process, also referred to as ISSG, is known by those practiced in the art to grow oxides on silicon having superior interfacial properties, which derive from simultaneous reduction and reoxidation processes. Only a very thin silicon dioxide layer, 6-8 Angstroms, is required since its main purpose is to achieve a low interfacial trap density at the silicon interface. The two-layer dielectric thus achieved has the advantages of being an excellent diffusion barrier and also possessing superior interface properties.

Thin ISSG layers grown directly on silicon have such a very fast growth rate that the process to grow an oxide layer of less than about 10 Angstroms is uncontrollable. Control of the ISSG silicon dioxide layer grown under the silicon nitride layer is greatly improved because the growth rate is slowed down by the need of the oxygen and hydrogen to diffuse through the silicon nitride layer. Small differences in oxidation time are not critical, since they only result in small differences in silicon dioxide thickness, and thus improved process reproducibility is achieved. The process of the invention renders the ISSG silicon dioxide-silicon nitride gate dielectric a manufacturable structure.

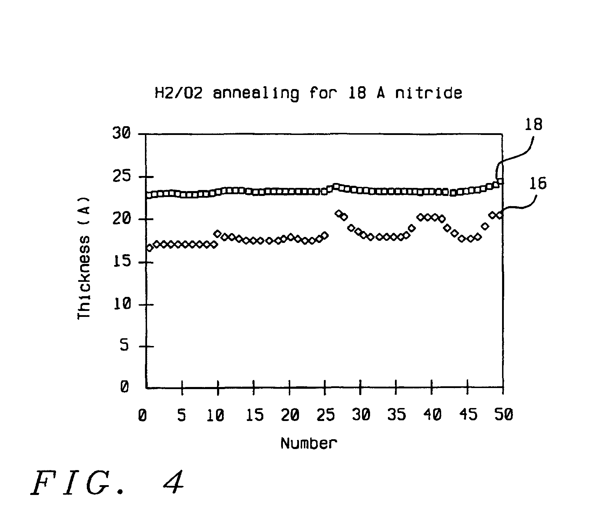

Another advantage of the process of the invention is an improvement in the uniformity of the gate dielectric. This can be explained with the aid of Fig. 3. A silicon nitride layer 14 had been deposited that is not uniform in thickness, as is depicted on the left of Fig.3. During the H₂/O₂ anneal the silicon dioxide layer grows faster under the thinner silicon nitride, which tends to equalize the total, nitride plus oxide, dielectric layer thickness, as depicted on the right of Fig.3. The magnitude of the improvement in gate dielectric thickness is shown in Fig.4. Ellipsometric thickness measurements are plotted for a nominally 18 Angstrom silicon nitride film before H₂/O₂ anneal, curve 16, and after H₂/O₂ anneal, curve 18, during which on the average about 4 Angstroms of silicon dioxide was grown. The standard deviation before anneal is 5.68%, while after anneal the standard deviation is reduced to 1.05%, a very significant reduction.

Thicker silicon nitride layers can be achieved through the following preferred embodiments of the invention. After RCA cleaning of the silicon surface, to eliminate particles and contamination, a first CVD silicon nitride layer is deposited directly on the silicon surface. This layer is sufficiently thin so that during the H₂/O₂ annealing step that follows a silicon oxide layer, 12, develops under the silicon nitride. The growth rate of the silicon dioxide layer is a strong function of the silicon nitride thickness because the oxygen and hydrogen must diffuse through the silicon nitride layer before reacting with the silicon. Thus for thick silicon nitride layers the 0₂ and H₂ penetration is too low and a silicon dioxide layer does not develop. However, for a sufficiently thin silicon nitride layer, this depends on other growth conditions, notably the temperature, a silicon dioxide layer does develop within a reasonable time. A second CVD silicon nitride layer is now deposited over the first silicon nitride layer without restriction on its thickness since the ISSG silicon dioxide layer had already been formed.

RCA cleaning procedures, to eliminate particles and contaminants from surfaces are well known to those skilled in the art. A clean surface is necessary to insure the integrity of the gate dielectric that is being formed. Preferably, the first CVD silicon nitride layer is deposited using LPCVD or RTCVD techniques. The thickness of the first CVD silicon nitride layer could be between about 8 to about 25 Angstroms. At such thickness the silicon nitride layer is reasonably uniform and yet the layer is thin enough to grow an appropriate oxide layer. The H₂/O₂ anneal, during which the underlying silicon dioxide layer is grown, can be performed at temperatures from about 700 to 1000 degrees Celsius, pressures from about 1 to 100 Torr, H₂/O₂ ratios from about 1:500 to 1:20 and duration from about 5 to 60 seconds. This H₂/O₂ oxidation process, also referred to as ISSG, is known by those practiced in the art to grow oxides on silicon having superior interfacial properties, which derive from simultaneous reduction and reoxidation processes. Only a very thin silicon dioxide layer, 6-8 Angstroms, is required since its main purpose is to achieve a low interfacial trap density at the silicon interface. The second CVD silicon nitride layer is also preferably deposited using LPCVD or RTCVD techniques. The multilayer dielectric thus achieved has the advantages of being an excellent diffusion barrier and also possessing superior interface properties.

Thin ISSG layers (< 10 Angstroms) grown directly on silicon have such a very fast growth rate that the process is uncontrollable. Control of the ISSG silicon dioxide layer grown under the silicon nitride layer is greatly improved because the growth rate is slowed down by the need of the 0₂ and H₂ to diffuse through the silicon nitride layer. Small differences in oxidation time are not critical, since they only result in small differences in silicon dioxide thickness, and thus improved process reproducibility is achieved. The process of the invention renders the ISSG silicon dioxide-silicon nitride gate dielectric a manufacturable structure even when a thick silicon nitride layer is required.

While the invention has been particularly shown and described with reference to the preferred embodiments thereof, it will be understood by those skilled in the art that various changes in form and detail may be made without departing from the spirit and scope of the invention.

## Claims

1. A method of forming an interfacial oxide layer at a semiconductor/dielectric interface comprising:
- providing a partially processed semiconductor wafer having semiconductor surfaces upon which gate dielectrics are to be disposed;
- cleaning said semiconductor surfaces of contaminants and particles;
- depositing a thin dielectric layer;
- annealing said semiconductor wafer in a gaseous environment to induce the growth of an oxide layer under said thin dielectric layer.

2. The method of Claim 1 wherein said deposited dielectric layer is CVD or LPCVD or RTCVD silicon nitride.

3. A method of forming an interfacial oxide layer at a semiconductor/dielectric interface comprising:
- providing a partially processed semiconductor wafer having semiconductor surfaces upon which gate dielectrics are to be disposed;
- cleaning said semiconductor surfaces of contaminants and particles;
- depositing a thin first dielectric layer;
- annealing said semiconductor wafer in a gaseous environment to induce the growth of an oxide layer under said thin first dielectric layer;
- depositing a second dielectric layer.

4. The method or Claim 1 or 3 wherein said semiconductor wafer is a silicon wafer

5. The method of Claim 1 or 3 wherein said semiconductor surface is a silicon surface.

6. The method of Claim 1 or 3 wherein said surface cleaning is accomplished using a RCA cleaning process.

7. The method of Claim 1 or 3 wherein said deposited thin first dielectric layer is CVD or LPCVD or RTCVD silicon nitride.

8. The method of Claim 1 or 3 wherein the thickness of said deposited dielectric layer is between about 8 to 25 Angstroms.

9. The method of Claim 1 or 3 wherein the annealing gas is a mixture of O₂ and H2.

10. The method of Claim 1 or 3 wherein the annealing temperature is between about 700 to 1000 degrees Celsius.

11. The method of Claim 1 or 3 wherein the annealing pressure is between about 1 to 100 Torr.

12. The method of Claim 1 or 3 wherein the H₂/O₂ ratio is between about 1:500 to 1:20.

13. The method of Claim 1 or 3 wherein the annealing duration is between 5 to 50 seconds.

14. The method of Claim 13 wherein said deposited second dielectric layer is CVD or LPCVD or RTCVD silicon nitride.
